# EUROPEAN PATENT SPECIFICATION

(11) **EP 4 401 522 B1**
(45) Date of publication and mention of the grant of the patent: **09.09.2026**
(21) Application number: 22867684.7
(22) Date of filing: 07.09.2022
(51) Int. Cl.: H05K 7/20, F28D 15/02, F28D 15/04, C25D 7/00, C23C 28/02, C23C 18/54, C23C 18/18, C23C 18/16

(54) **VAPOR CHAMBER AND METHOD FOR MANUFACTURING SAME**
DAMPFKAMMER UND VERFAHREN ZUR HERSTELLUNG DAVON
CHAMBRE À VAPEUR ET PROCÉDÉ DE FABRICATION DE CELLE-CI

(30) Priority: 07.09.2021 KR 20210118742; 06.09.2022 KR 20220112729
(43) Date of publication of application: 17.07.2024
(73) Proprietor: KMW Inc., Hwaseong-si, Gyeonggi-do 18462 (KR)
(72) Inventor: LEE, Kang Hyun, Hwaseong-si Gyeonggi-do 18442 (KR); KIM, Hyung Seok, Suwon-si Gyeonggi-do 16536 (KR); IM, Hyung Gun, Hwaseong-si Gyeonggi-do 18463 (KR)
(74) Representative: impuls legal PartG mbB
(86) International application number: PCT/KR2022/013408
(87) International publication number: WO 2023/038415

(56) References cited:
- KR-A- 20200 140 009
- KR-B1- 102 257 692
- US-A1- 2006 222 423
- US-A1- 2012 175 086
- SEMENIC TADEJ; GOULD KYLE D.; CHEN YA-CHI: "Flight deck heat spreader", APPLIED THERMAL ENGINEERING, PERGAMON, OXFORD, GB, vol. 94, 2 November 2015 (2015-11-02), GB , pages 1 - 12, XP029409476, ISSN: 1359-4311, DOI: 10.1016/j.applthermaleng.2015.10.113

## Description

### [Technical Field]

The present disclosure relates to a vapor chamber and a method of producing the same, and more particularly, to a vapor chamber with improved heat conduction performance, in which a wick is able to be formed easily having a desired pore size without subjecting to a complicated sintering process, and a method of producing the same.

### [Background Art]

While electronic devices have seen remarkable growth in terms of improvements in performance recently, the amount of system heat generated within the devices has also increased relatively significantly in addition to improved performance. Besides, the devices have also been continuously reduced in size and attempts have been made to concentrate circuits within smaller confined spaces. Hence, the heat generated from these highly integrated components (heating elements) may degrade or deteriorate performance of the devices, making it an increasingly major issue in the industry of manufacture of electronic devices to effectively dissipate system heat.

To solve this issue, heat sinks are commonly used that may each be basically composed of a base plate to receive heat by direct contact with a heat source to be cooled and a plurality of cooling fins protruding from the base plate to transfer heat from the base plate to the air therearound. These heat sinks are being actively researched in the materials and designs thereof according to the intended purpose thereof, but in common, they are being developed to increase the area in contact with air by maximizing the surface areas of the cooling fins for effective dissipation of heat.

Such a heat sink is one of heat dissipation mechanisms that mainly function to radiate system heat within electronic devices to the outside rather than in direct thermal contact with surfaces of heating elements. When a heating element is spaced far away from a base plate, effective heat conduction is difficult. Accordingly, a heat pipe and a vapor chamber are often employed as heat conductors that transfer heat by direct thermal contact with surfaces of heating elements.

The heat pipe and the vapor chamber are distinguished depending on the external appearance thereof, namely, whether to have a pipe shape or a plate shape. In particular, the vapor chamber is a heat transfer medium, which has one surface in direct thermal contact with the heating surface of a heating element and the other surface in thermal contact with outdoor air or the surface of a heat dissipation mechanism such as a heat sink and is provided with a wick having multiple pores therein to transfer heat from the heating element through heat conduction between one surface and the other surface while moving a refrigerant filled therein through the wick by capillarity.

Here, the multiple pores of the wick for moving the refrigerant by capillarity are typically formed through a sintering process of sintering Cu powder at a predetermined temperature. The gap between particles in the wick formed through the sintering process is narrow to cause a small pore size, which may lead to less capillary force than required.

In addition, since the raw material of the wick is limited to Cu powder suitable for the sintering temperature of the sintering process, it may be difficult to employ other materials with excellent thermal conductivity.

Moreover, if the raw materials for the wick, the chamber body plate, and the chamber cover plate are different, the sintering bond strength therebetween may decrease to space them apart, resulting in deterioration in thermal conductivity.

US 2012/175086 A1 discloses the preamble of claim 1 and illustrates for example a heat pipe that is provided having an enclosed vapor chamber and a wick disposed within the vapor chamber. The wick comprises a plurality of lands having a thickness and a plurality of vents formed between the lands, wherein each vent includes a layer of wick having a thickness that is less than the thickness of the lands

Semenic Tadej; Gould Kyle D.; Chen Ya-Chi: "Flight deck heat spreader",APPLIED THERMAL ENGINEERING, PERGAMON, OXFORD, GB, vol. 94, 2 November 2015 (2015-11-02), pages 1-12, XP029409476,GB, relates to a Flight Deck Heat Spreader (FDHS) that consists of aluminum panels with supporting pillars, aluminum wick sintered directly to panels and supporting pillars, water with corrosion inhibitor working fluid, and is sealed by welding individual panels together. To minimize or eliminate hydrogen generation in an aqueous environment, nickel plating of panels with wick was evaluated.
KR 2020 0140009 A, KR 102 257 692 B1, and US 2006/222423 A1 disclose further examples of vapor chambers.

### [DISCLOSURE]

### [Technical Problem]

The present disclosure has been made in view of the above-mentioned problems, and an object of the present disclosure is to provide a vapor chamber with improved thermal conductivity, which is capable of completely excluding a complicated and energy-consuming sintering process and having multiple pores whose size is suitable for flow according to capillarity of refrigerant, and a method of producing the same.

The present disclosure is not limited to the above-mentioned object, and other objects of the present disclosure can be clearly understood by those skilled in the art to which the present disclosure pertains from the following description.

### [Technical Solution]

The invention is defined in the independent claims. Further advantageous embodiments are defined in the dependent claims.

### [Advantageous Effects]

A vapor chamber and a method of producing the same according to exemplary embodiments of present disclosure can achieve various effects as follows.

Firstly, energy consumption can be minimized since a sintering process may be completely excluded in the formation of multiple pores in a wick.

Secondly, it is possible to increase capillary force by increasing the particle gap between aluminum powders bonded through electroless Ni plating and wet Cu plating processes to enable the formation of relatively larger pores than the pores formed through the sintering process.

Thirdly, it is possible to enhance overall thermal conductivity through the improvement in fluidity of filling refrigerant by increasing capillary force.

### [Description of Drawings]

FIG. 1 is a flowchart illustrating a method of producing vapor chambers according to an embodiment of the present disclosure.
FIG. 2 is a flowchart subdividing a material preparation process of the processes in FIG. 1.
FIG. 3 is a cross-sectional view illustrating a principle of heat dissipation in a vapor chamber according to an embodiment of the present disclosure.
FIG. 4 is a photomicrograph for comparing a particle size, a cluster size, and a pore size between (a) a Cu powder sintered product manufactured through a sintering process and (b) an Al powder sintered product manufactured by the method according to the embodiment of the present disclosure.
FIG. 5 is a photomicrograph for comparing an overall inter-particle distance between (a) the Cu powder sintered product manufactured through the sintering process and (b) the Al powder sintered product manufactured by the method according to the embodiment of the present disclosure.

### [List of Reference Numerals]

5: printed circuit board 7: heating element
10: vapor chamber 11: chamber body plate
12: chamber cover plate 14: wick
15: fastening screw 16: casing
S10: material preparation process S11: degreasing process
S12: alkaline etching process S13: desmut process
S14: zincate treatment process S20: electroless Ni plating process
S30: wet Cu plating process S40: washing and drying process

### [Best Mode]

Hereinafter, a vapor chamber and a method of producing the same according to exemplary embodiments of the present disclosure will be described in detail with reference to the accompanying drawings.

It should be noted that reference numerals are added to the components of the accompanying drawings to facilitate understanding of the embodiments described below and the same reference numbers will be used throughout the drawings to refer to the same or like parts wherever possible. In certain embodiments, detailed descriptions of constructions or functions well known in the art may be omitted to avoid obscuring appreciation of the disclosure by a person of ordinary skill in the art.

The terms such as "first", "second", "A", "B", "(a) ", and "(b)" may be used herein to describe components in the embodiments of the present disclosure. These terms are not used to define an essence, order or sequence of a corresponding component but used merely to distinguish the corresponding component from other component(s). Unless otherwise defined, all terms, including technical and scientific terms, used herein have the same meaning as commonly understood by one of ordinary skill in the art. It will be further understood that terms, such as those defined in commonly used dictionaries, should be interpreted as having a meaning that is consistent with their meaning in the context of the relevant art and the present disclosure, and will not be interpreted in an idealized or overly formal sense unless expressly so defined herein.

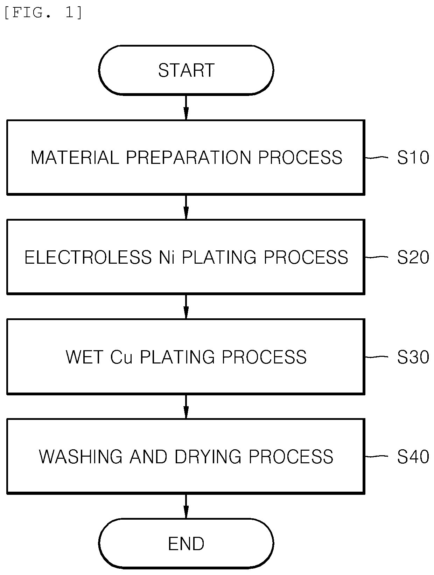

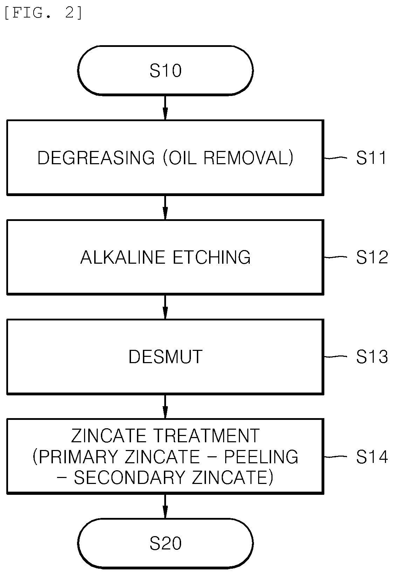

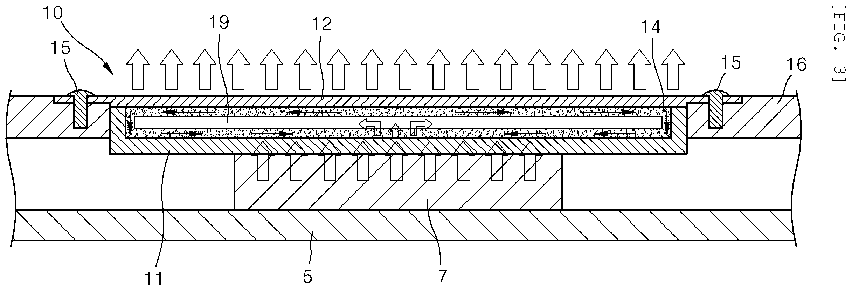

FIG. 1 is a flowchart illustrating a method of producing vapor chambers according to an embodiment of the present disclosure. FIG. 2 is a flowchart subdividing a material preparation process of the processes in FIG. 1. FIG. 3 is a cross-sectional view illustrating a principle of heat dissipation in a vapor chamber according to an embodiment of the present disclosure.

First, the principle of heat dissipation in the vapor chamber according to the embodiment of the present disclosure will be described with reference to FIG. 3.

The vapor chamber, which is designated by reference numeral 10, produced by the method according to the embodiment of the present disclosure is one of heat dissipation components that may use a heat dissipation method based on the concept of excluding the induction of phase change of refrigerant by a compressor. The vapor chamber 10 is a representative heat dissipation mechanism designed to cool a specific heating element, which is electrically driven and generates heat, by transferring heat while causing a phase change only by heat supplied from the outside at atmospheric pressure without using a compressor.

More specifically, the vapor chamber 10 includes, as illustrated in FIG. 3, a chamber body plate 11 that has a refrigerant filling space defined to be filled with a refrigerant therein and a vacuum layer 19 formed in the middle thereof to have a predetermined thickness, the chamber body plate 11 having one surface placed in close contact with the heating surface of a heating element 7 mounted on one side of a printed circuit board 5 bonded to the inside of an electronic device and the other surface that is open, a chamber cover plate 12 bonded to shield the other open surface of the chamber body plate 11, and a wick 14 formed as a predetermined thickness layer around the vacuum layer 19 in the refrigerant filling space, which is a space between the chamber body plate 11 and the chamber cover plate 12, and having at least multiple pores through which the refrigerant filled in the refrigerant filling space flows by capillary force.

As illustrated in FIG. 3, when heat is transferred to the liquid refrigerant inside through the chamber body plate 11 by the heating element 7 (i.e., heat source) provided on one side of the chamber body plate 11 in the thickness direction thereof, the liquid refrigerant flows toward the wick 14 close to the chamber cover plate 12 while causing a phase change to a gas refrigerant during reaching the vacuum layer 19, and the gas refrigerant causes a phase change to the liquid refrigerant in the wick 14 on the side of the chamber cover plate 12 (i.e., on the heat dissipation side). The liquid refrigerant then flows to a region close to the heating element 7 (i.e., to the heat source) by capillary force along the wick 14 having the multiple pores formed therein, so this flow is repeatedly circulated.

In this case, the gas refrigerant flowing toward the chamber body plate 11 (i.e., to the heat dissipation side) may change phase into the liquid refrigerant by exchanging heat with the wick 14, which has a relatively low temperature, on the side of the chamber cover plate 12. At the same time, the heat exchanged may sequentially flow to the wick 14, and the chamber cover plate 12, and the heat transferred to the chamber cover plate 12 may be radiated directly to the outside or may be transferred to a heat sink (not shown) formed integrally with the chamber cover plate 12 for exposure to the outside to be finally radiated to the outside.

Here, the multiple pores formed in the wick 14 may allow the incoming refrigerant to pass therethrough immediately if it is a gas refrigerant and may function to increase a heat transfer area when the gas refrigerant exchanges relatively low heat with the outside (e.g., the chamber cover plate 12) while flowing. On the other hand, if the incoming refrigerant is a liquid refrigerant, the multiple pores may function to quickly induce a phase change to a gas refrigerant while increasing a heat transfer area with the liquid refrigerant and to additionally induce a more active flow of the liquid refrigerant by inducing capillarity according to the surface tension properties of the liquid refrigerant depending on the pore size.

For reference, the refrigerant filled in the refrigerant filling space (i.e., the wick 14) between the chamber body plate 11 and the chamber cover plate 12 may contain one of acetone, ammonia, and distilled water.

As illustrated in FIG. 3, it is preferable that the multiple pores formed in the wick 14 be sized such that the gas refrigerant changes phase into a liquid refrigerant in the wick 14 on the side of the chamber cover plate 12 where the gas refrigerant flows and clusters, and then flows around the periphery of the vacuum layer 19 again toward the wick 14, which is close to the heating element 7 on the inner surface of the chamber body plate 11, and the liquid refrigerant smoothly flows by its own surface tension or capillary force.

Here, the multiple pores formed in the region of the wick 14 that is in contact with the inner surfaces of the chamber body plate 11 and the chamber cover plate 12 may be provided to communicate with pores between Ni plating layers formed through an electroless Ni plating process, which will be described later, using aluminum powder, and to communicate with a capillary pattern passage (not shown) provided such that the liquid refrigerant after heat exchange flows by capillary force again toward the heating element 7 by surface tension.

Meanwhile, the chamber body plate 11 and the chamber cover plate 12 with the wick 14 provided therebetween may be fastened to a casing 16 of an electronic device or a heat sink, which requires heat dissipation, using fastening screws 15.

Hereinafter, the important technical features of the method of forming the wick 14 provided in the vapor chamber 10 will be described in the embodiment of the present disclosure.

More specifically, referring to FIGS. 1 and 2, the method of producing vapor chambers according to the embodiment of the present disclosure includes a material preparation process S10 that prepares each raw material for a chamber body plate 11, a chamber cover plate 12, and a wick 14, wherein the chamber body plate 11 has a refrigerant filling space filled with a refrigerant therein and a vacuum layer 19 with a predetermined thickness, the chamber cover plate 12 shields an open surface to define the refrigerant filling space together with the chamber body plate 11, and the wick 14 is formed in the refrigerant filling space.

In addition, the method may include an electroless Ni plating process S20 that performs electroless Ni plating after a predetermined amount of aluminum (Al) powder, which is the raw material of the wick 14, is placed in a region corresponding to the refrigerant filling space defined by the chamber body plate 11 or the chamber cover plate 12 prepared through the material preparation process S10, a wet Cu plating process S30 that additionally performs Cu plating on the wick 14 formed through the electroless Ni plating process S20 to coat the wick 14 to a predetermined thickness, and a washing and drying process S40 that washes and dries the chamber body plate 11 with the wick 14 formed therein.

The material preparation process S10, as illustrated in FIG. 2, may prepare the raw materials for the chamber body plate 11, the chamber cover plate 12, and the wick 14 by performing a degreasing (oil removal) process S11, an alkaline etching process S12, a desmut process S13, and a zincate treatment process S14.

The degreasing (oil removal) process S11 may be a process of removing foreign substances and organic matter from the aluminum (Al) powder, which is the raw material of the wick 14, using an ultrasonic device. Here, the degreasing (oil removal) process S11 may be performed for 1 minute in an atmosphere of temperature of 45 ± 5°C. The degreasing (oil removal) process S11 may be performed on the aluminum plate, which is the each raw material of the chamber body plate 11 and the chamber cover plate 12, under the same conditions.

The alkaline etching process S12 may be a process of immersing the aluminum powder or the aluminum plate, which has been subjected to the degreasing process S11, in an alkaline mixture to treat the surface of the aluminum product with alkali. Here, the alkaline etching process S12 may be performed for 10 ± 5 seconds in an atmosphere of temperature of 15 ± 5°C, and the alkaline mixture may have a concentration of 15 ± 5 g/L. The alkaline etching process S12 may be, especially for the chamber body plate 11, a process of chemically corroding a region therein corresponding to the refrigerant filling space. In this case, the alkaline etching process S12 may be performed at a temperature of 60 ± 5°C, and the alkaline mixture may have a concentration of 50 ± 5 g/L.

The desmut process S13 may be a process of removing smut by mixing a sulfuric acid (H₂SO₄) undiluted solution with a chemical containing a special additive of nitric acid (HNO₃) type base in a pure (H₂O) solution. In particular, when an aluminum material is etched with the above-mentioned alkaline mixture, the etching speed of an alloy component such as Mg, Cu, Si, or Mn differs from the etching speed of the base material, resulting in the formation of black smut on the surface thereof. Accordingly, the above-mentioned desmut process S13 using high-concentration nitric acid and sulfuric acid undiluted solutions is essential for removal of the black smut.

Here, it is preferable to mix the sulfuric acid (H₂SO₄) to have a concentration of 100 ± 10 ml/L with the nitric acid (HNO₃) to have a concentration of 60 ± 10 ml/L.

The zincate treatment process S14 may be generally a pretreatment process when electroless Ni plating is applied to an aluminum alloy product, and may include a primary zincate process of replacing zinc, a zincate peeling process of performing oxide film removal and activation treatment, and a secondary zincate process of replacing zinc again.

When the aluminum (Al) powder, which is the raw material of the wick 14 within the chamber body plate 11 prepared through the material preparation process S10, is compressed and filled in a region corresponding to the refrigerant filling space, and is then immersed in a previously prepared nickel salt aqueous solution using a dedicated jig, the electroless Ni plating process S20 may be performed in which the aluminum powder, which is the raw material of the wick 14, is bonded in particles (particle units) and cluster units, which are the cluster units of particles, thereby forming multiple pores.

Likewise, the electroless Ni plating process S20 may be performed by placing the aluminum (Al) powder, which is the raw material of the wick 14, having a predetermined thickness (or predetermined amount) on the upper side of the chamber cover plate 12 prepared through the material preparation process S10, and then immersing the aluminum powder in the previously prepared nickel salt aqueous solution using the dedicated jig. In this case, the electroless Ni plating process S20 for the chamber body plate 11 and the chamber cover plate 12 is preferably performed under the same conditions so as to have pores of similar sizes and similar degree of bonding force.

Here, the electroless Ni plating process S20 may be a process of forming multiple pores while bonding the aluminum powder, which is the raw material of the wick 14, in particle units.

In other words, a Ni plating layer having a predetermined thickness may be formed on the outer surface of the aluminum powder in particle units, in which case the Ni plating layer is also bonded with a number of other surrounding aluminum powders in particle units to form clusters in the size of so-called cluster units, with the consequence that the multiple pores are formed between particles.

In addition, the electroless Ni plating process S20 may be a process of bonding the wick 14 to the inner surface of the chamber body plate 11 or the chamber cover plate 12 made of aluminum, which is the same material as the wick 14, with a predetermined bonding force.

In other words, the above-mentioned Ni plating layer may be formed on the outer surface of the aluminum powder formed in particle and cluster units by the electroless Ni plating process S20, and at the same time, the aluminum powder in particle and cluster units may be bonded to the chamber body plate 11 or the chamber cover plate 12 by the Ni plating layer.

In this case, film treatment or shielding treatment is preferably performed so that the above-mentioned vacuum layer 19 is formed within the chamber body plate 11 with the refrigerant filling space defined therein. In addition, even when the wick 14 formed on the chamber cover plate 12 occupies a portion of the volume forming the vacuum layer 19, it will require the same film treatment or shielding treatment as that of the chamber body plate 11.

More specifically, after the chamber body plate 11 is processed to form the above-mentioned vacuum layer 19 in the space within the chamber body plate 11, aluminum powder may be filled so that the wick 14 is formed as a predetermined thickness layer around the vacuum layer 19, and the above-mentioned electroless Ni plating process S20 and the wet Cu plating process S30 to be described later may be performed, thereby manufacturing the wick 14 having multiple pores of desired specifications.

In addition, if the vacuum layer is required to be formed in the chamber cover plate 12 as necessary, aluminum powder may be placed so that the wick 14 is formed as a predetermined thickness layer on the inner surface of the chamber cover plate 12 corresponding to the periphery of the vacuum layer 19 after film treatment or shielding treatment for forming the vacuum layer 19, and the above-mentioned electroless Ni plating process S20 and the wet Cu plating process S30 to be described later may be performed, thereby forming the wick 14 having pores sized similarly to that formed in the chamber body plate 11.

In particular, the chamber cover plate 12 is manufactured separately from the wick 14, and then bonded to shield the open portion of the chamber body plate 11 after the electroless Ni plating process S20 and the wet Cu plating process S30. In this regard, the chamber cover plate 12 may be welded and filled with a liquid refrigerant therein to shield the open portion of the chamber body plate 11 by polishing and chipping away the portion of the wick 14 that comes into contact therewith during bonding for shielding to achieve face-to-face contact with the outer end surface of the wick 14.

In this case, the bonding method of the chamber cover plate 12 to the chamber body plate 11 is not limited to the welding, and any method may be employed as long as the refrigerant filled inside does not leak.

Meanwhile, the wick 14 manufactured through the electroless Ni plating process S20 is bonded to the inner surface of the chamber body plate 11 or the chamber cover plate 12 with a predetermined bonding force as described above, but the bonding force may be small compared to when manufacturing the wick 14 through a sintering process. Therefore, the method of producing vapor chambers according to the embodiment of the present disclosure may further include the wet Cu plating process S30.

The wet Cu plating process S30 may be a process of forming a Cu plating layer on the inner surfaces of the wick 14 and the chamber body plate 11 and the inner surfaces of the wick 14 and the chamber cover plate 12 by a typical electroplating method. Specifically, the wet Cu plating process S30 may be a process of additionally forming a Cu plating layer on the Ni plating layer on the surface of the wick 14 formed through the electroless Ni plating process S20 to form the multiple pores sized such that the refrigerant filled in the refrigerant filling space flows by capillarity.

It may also be understood that the wet Cu plating process S30 is a process of further increasing the predetermined bonding force of the wick 14 to the chamber body plate 11 by the Ni plating layer formed through the electroless Ni plating process S20 and the predetermined bonding force of the wick 14 to the chamber cover plate 12 by the Cu plating layer. In other words, the wet Cu plating process S30 may additionally form the Cu plating layer on the outer surface of the Ni plating layer of particles that still remain in particle units even through the electroless Ni plating process S20 to involve in bonding in cluster units, or may additionally form the Cu plating layer on the outer surface of the Ni plating layer to add the bonding force to the inner surface of the chamber body plate 11 or the chamber cover plate 12.

The increase in the predetermined bonding force of the wick 14 to the chamber body plate 11 and the predetermined bonding force of the wick 14 to the chamber cover plate 12 may minimize separation and detachment between the wick 14 and the chamber body plate 11 and between the wick 14 and the chamber cover plate 12. Thus, the heat from the heating element 7 may be transferred via the chamber body plate 11 to the wick 14 with high thermal conductivity, which may significantly increase overall thermal conductivity.

Therefore, the vapor chamber 10 according to the embodiment of the present disclosure produced by the above-mentioned method may be defined as follows. This definition should be an important standard in interpreting the true scope of rights of the present disclosure.

In other words, the vapor chamber 10 according to the embodiment of the present disclosure includes the chamber body plate 11 having one surface placed in close contact with the heating surface of the heating element and the other surface that is open, and having the refrigerant filling space filled with a refrigerant therein and defined to have a predetermined thickness, the chamber cover plate 12 bonded to shield the other open surface of the chamber body plate 11, and the wick 14 formed as a predetermined thickness layer around the vacuum layer 19 in the refrigerant filling space, which is a space between the chamber body plate 11 and the chamber cover plate 12, and having at least the multiple pores through which the refrigerant (especially, liquid refrigerant) filled in the refrigerant filling space flows by appropriate capillary force.

The wick 14 may have the multiple pores formed through the electroless Ni plating process S20 with the aluminum powder filled in the refrigerant filling space. The multiple pores formed in the wick 14 may be formed by the Ni plating layer formed on the outer surface of the aluminum powder in particles (particle units) or cluster units. As described above, the Cu plating layer may be additionally formed on the outer surface of the Ni plating layer through the wet Cu plating process S30 to form the multiple pores sized such that the refrigerant flows by capillarity.

In addition, the chamber body plate 11 and the chamber cover plate 12 may be made of an aluminum material (in the form of a plate), which is the same material as the wick 14 before the electroless Ni plating process S20. As described above, the wick 14 may be bonded to the inner surfaces of the chamber body plate 11 and the chamber cover plate 12 with a predetermined bonding force through the electroless Ni plating process S20.

Furthermore, the predetermined bonding force between the inner surface of the chamber body plate 11 and the wick 14 and between the inner surface of the chamber cover plate 12 and the wick 14 may be further increased by addition of the wet Cu plating process S30. Therefore, as described above, the heat generated by the heating element 7 can be smoothly radiated to the outside while maintaining higher thermal conductivity.

Meanwhile, although not illustrated, it is natural that, after the electroless Ni plating process S20 and the wet Cu plating process S30 are performed separately on the chamber body plate 11 and the chamber cover plate 12, an additional bonding process may be performed of welding the chamber body plate 11 and the chamber cover plate 12 so that the wick 14 is in surface contact with the chamber body plate 11 and the chamber cover plate 12.

However, more advantageously, the wick 14 is filled within the chamber body plate 11 and then the portions thereof are bonded to each other through the above-mentioned electroless Ni plating process S20 and wet Cu plating process S30. Accordingly, a bonding process may also be employed of welding only the chamber cover plate 12.

In this case, although not illustrated in the drawings, the portion of the wick 14 in contact with the inner surface of the chamber cover plate 12 may have an uneven outer surface since the multiple pores are formed simply through the Ni plating process S20. Accordingly, after the outer portion of the wick 14 is cut to be flat, the portion of the wick 14 in contact with the inner surface of the chamber cover plate 12 may be machined using a laser processing machine (not shown) to form a predetermined capillary pattern passage (not shown) in communication with the multiple pores.

The capillary pattern passage may be formed by laser processing between the inner surface of the chamber cover plate 12 and the outer surface of the wick 14 while communicating with the multiple pores, to provide a movement path by capillary force in an opposite direction where the heating element is provided when the refrigerant filled in the chamber body plate 11 changes phase into a liquid refrigerant due to heat exchange.

After the capillary pattern passage is machined on the outer surface of the wick 14 by the laser processing machine, the chamber cover plate 12 may be bonded by one of the above-mentioned welding and various bonding methods to cover the open outer surface of the chamber body plate 11 so that the inner surface of the chamber cover plate 12 is in surface contact with the outer surface of the wick 14 on which the capillary pattern passage is machined.

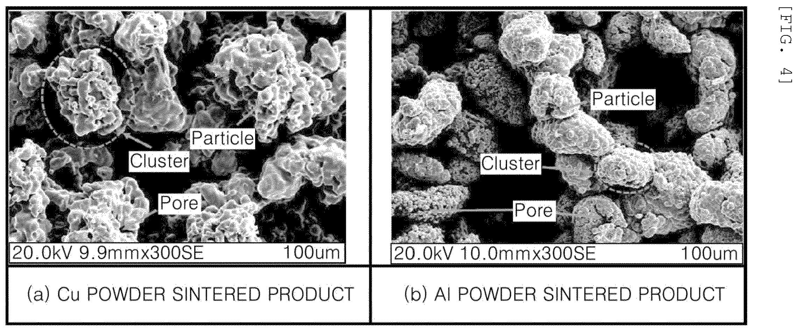

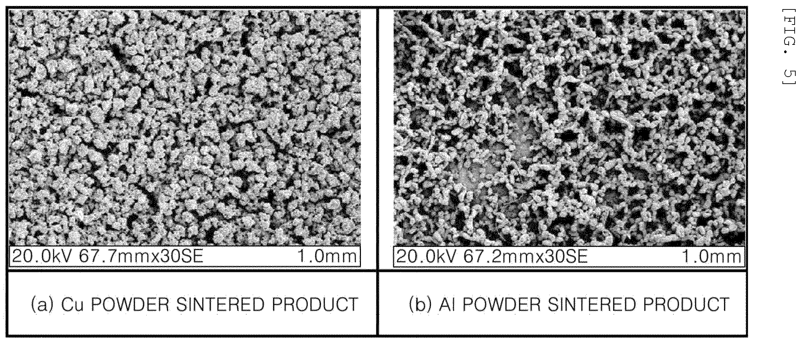

FIG. 4 is a photomicrograph for comparing a particle size, a cluster size, and a pore size between (a) a Cu powder sintered product manufactured through the sintering process and (b) an Al powder sintered product manufactured by the method according to the embodiment of the present disclosure. FIG. 5 is a photomicrograph for comparing an overall inter-particle distance between (a) the Cu powder sintered product manufactured through the sintering process and (b) the Al powder sintered product manufactured by the method according to the embodiment of the present disclosure.

FIG. 4(a) is a photograph magnified 300 times of the Cu powder sintered product through the typical sintering process by a microscope, and it can be visually seen that individual particles are melt-bonded. In addition, it can be seen from FIG. 4 that the particle size and the cluster size, which is a combination of particles, are relatively large compared to those in FIG. 4(b). Due to melt bonding between particles, most of the pores within the cluster are closed, which may cause a decrease in capillary force and thus reduce overall heat conduction performance.

On the other hand, FIG. 4(b) is a photograph magnified 300 times of the wick 14 manufactured by the method according to the embodiment of the present disclosure. In FIG. 4(b), it can be visually that the capillary force is relatively improved since individual particles are chemically bonded, the pores within the cluster are open, and the gap between clusters is also open.

In other words, the wick 14 manufactured by the method according to the embodiment of the present disclosure, as illustrated in FIG. 5(b), may have a size of approximately 100 µm and have a size (approximately 130 µm) of particles of the sintered product illustrated in FIG. 5(a). Accordingly, it can be seen that the wick 14 generally forms larger pores when forming a cluster, thereby improving capillary force.

As described above, in the vapor chamber and the method of producing the same according to the embodiments of the present disclosure, it is somewhat difficult to control porosity, but it is possible to significantly enhance overall heat conduction performance by forming the multiple pores with improved capillary force compared to the wick formed through the sintering process as well as by improving bonding force to the chamber body plate 11 or the chamber cover plate 12.

The vapor chamber and the method of producing the same according to the exemplary embodiments of the present disclosure have been described above in detail with reference to the accompanying drawings. However, the exemplary embodiments of the present disclosure should not be construed as limiting the technical idea of the disclosure. It will be apparent to those skilled in the art that the scope of the present disclosure is limited only by the appended claims. Therefore, the true scope of rights of the present disclosure should be defined by the appended claims.

### [Industrial Applicability]

The present disclosure is directed to a vapor chamber with improved thermal conductivity, which is capable of completely excluding a complicated and energy-consuming sintering process and having multiple pores whose size is suitable for flow according to capillarity of refrigerant, and a method of producing the same.

## Claims

1. A vapor chamber (10) comprising:
a chamber body plate (11) having one surface placed in close contact with a heating surface of a heating element (7) and the other surface that is open, the chamber body plate (11) having a refrigerant filling space filled with a refrigerant therein and defined to have a predetermined thickness;
a chamber cover plate (12) bonded to shield the other open surface of the chamber body plate (11); and
a wick (14) formed in the refrigerant filling space, which is a space between the chamber body plate (11) and the chamber cover plate (12), the wick (14) having at least multiple pores through which the refrigerant filled in the refrigerant filling space flows,
**characterized in that** the wick (14) comprises a Ni plating layer formed on an outer surface of aluminum powder bonded in particle units, wherein the chamber body plate (11) and the chamber cover plate (12) are made of aluminum, which is the same material as the wick (14) before an electroless Ni plating process, wherein the wick (14) further comprises a Cu plating layer formed on an outer surface of the Ni plating layer.

2. The vapor chamber (10) according to claim 1, wherein the chamber body plate (11) and the wick (14) or the chamber cover plate (12) and the wick (14) are bonded with a predetermined bonding force through the electroless Ni plating process.

3. The vapor chamber (10) according to claim 1, wherein a predetermined bonding force between an inner surface of the chamber body plate (11) and the wick (14) is further increased by addition of a wet Cu plating process to form the Cu plating layer.

4. The vapor chamber (10) according to claim 3, wherein the multiple pores formed in the wick (14) are sized such that the refrigerant flows through capillarity by the Cu plating layer formed through the wet Cu plating process.

5. A method of producing vapor chambers according to claim 1, comprising:
a material preparation process (S10) of preparing each raw material for a chamber body plate (11), a chamber cover plate (12), and a wick (14), the chamber body plate (11) having a refrigerant filling space filled with a refrigerant therein, the chamber cover plate (12) configured to shield an open surface to define the refrigerant filling space together with the chamber body plate (11), the wick (14) being formed in the refrigerant filling space; and
an electroless Ni plating process (S20) of performing electroless Ni plating after a predetermined amount of aluminum powder, which is the raw material of the wick (14), is placed in a region corresponding to the refrigerant filling space defined by the chamber body plate (11) or the chamber cover plate (12) prepared through the material preparation process, further comprising a wet Cu plating process (S30) of additionally performing Cu plating on the wick (14) formed through the electroless Ni plating process.

6. The method according to claim 5, wherein the material preparation process precedes a zincate treatment process (S14) after forming an empty space corresponding to the refrigerant filling space by etching at least one of the chamber body plate (11) and the chamber cover plate (12) prepared in the form of an aluminum plate so that the wick (14) is formed in the refrigerant filling space.

7. The method according to claim 5, wherein the electroless Ni plating process (S20) is a process of forming the multiple pores while bonding the aluminum powder, and of simultaneously bonding the wick (14) to an inner surface of the chamber body plate (11) or the chamber cover plate (12) made of aluminum, which is the same material as the wick (14), with a predetermined bonding force.

8. The method according to claim 5, wherein the wet Cu plating process (S30) is a process of plating a copper layer on a surface of the wick (14) formed through the electroless Ni plating process to form the multiple pores sized such that the refrigerant filled in the refrigerant filling space flows by capillarity.

9. The method according to claim 5, wherein the wet Cu plating process (S30) is a process of further increasing a predetermined bonding force of the wick (14) to the chamber body plate (11) or of the wick (14) to the chamber cover plate (12) made through the electroless Ni plating process.

10. The method according to claim 5, wherein after the electroless Ni plating process (S20) and the wet Cu plating process (S30) are performed separately on the chamber body plate (11) and the chamber cover plate (12), an additional bonding process is performed of welding the chamber body plate (11) and the chamber cover plate (12) so that the wick (14) is in surface contact with the chamber body plate (11) and the chamber cover plate (12).

## Patentansprüche

1. Dampfkammer (10), umfassend:
eine Kammerkörperplatte (11), deren eine Oberfläche in engem Kontakt mit einer Heizfläche eines Heizelements (7) steht und deren andere Oberfläche offen ist, wobei die Kammerkörperplatte (11) einen mit einem Kältemittel gefüllten Kältemittel-Füllraum aufweist, der so ausgebildet ist, dass er eine vorbestimmte Dicke aufweist;
eine Kammerdeckplatte (12), die so angebracht ist, dass sie die andere offene Oberfläche der Kammerkörperplatte (11) abdeckt; und
einen Docht (14), der in dem Kältemittel-Füllraum ausgebildet ist, bei dem es sich um einen Raum zwischen der Kammerkörperplatte (11) und der Kammerdeckplatte (12) handelt, wobei der Docht (14) mindestens mehrere Poren aufweist, durch die das in den Kältemittel-Füllraum eingefüllte Kältemittel fließt,
**dadurch gekennzeichnet, dass** der Docht (14) eine Ni-Beschichtungsschicht umfasst, die auf einer Außenfläche von in Partikeleinheiten gebundenem Aluminiumpulver ausgebildet ist, wobei die Kammerkörperplatte (11) und die Kammerabdeckplatte (12) aus Aluminium bestehen, das vor einem chemischen Ni-Beschichtungsverfahren dasselbe Material wie der Docht (14) ist, wobei der Docht (14) ferner eine Cu-Beschichtungsschicht aufweist, die auf einer Außenfläche der Ni-Beschichtungsschicht ausgebildet ist.

2. Dampfkammer (10) nach Anspruch 1, wobei die Kammerkörperplatte (11) und der Docht (14) oder die Kammerdeckplatte (12) und der Docht (14) durch den chemischen Ni-Beschichtungsprozess mit einer vorbestimmten Haftkraft verbunden sind.

3. Dampfkammer (10) nach Anspruch 1, wobei eine vorbestimmte Haftkraft zwischen einer Innenfläche der Kammerkörperplatte (11) und dem Docht (14) durch Hinzufügen eines Nass-Cu-Beschichtungsverfahrens zur Bildung der Cu-Beschichtungsschicht weiter erhöht wird.

4. Dampfkammer (10) nach Anspruch 3, wobei die im Docht (14) ausgebildeten zahlreichen Poren so dimensioniert sind, dass das Kältemittel durch Kapillarwirkung durch die mittels des Nass-Cu-Beschichtungsverfahrens gebildete Cu-Beschichtungsschicht fließt.

5. Verfahren zur Herstellung von Dampfkammern gemäß Anspruch 1, umfassend:
einen Materialvorbereitungsprozess (S10) zur Vorbereitung der jeweiligen Rohmaterialien für eine Kammerkörperplatte (11), eine Kammerabdeckplatte (12) und einen Docht (14), wobei die Kammerkörperplatte (11) einen mit einem Kältemittel gefüllten Kältemittel-Füllraum aufweist, die Kammerabdeckplatte (12) so ausgebildet ist, dass sie eine offene Oberfläche abschirmt, um gemeinsam mit der Kammerkörperplatte (11) den Kältemittel-Füllraum zu begrenzen, und der Docht (14) im Kältemittel-Füllraum ausgebildet ist; und
einem chemischen Ni-Beschichtungsverfahren (S20) zur Durchführung einer chemischen Ni-Beschichtung, nachdem eine vorbestimmte Menge an Aluminiumpulver, das das Ausgangsmaterial des Dochtes (14) in einen Bereich eingebracht wurde, der dem durch die im Materialvorbereitungsverfahren hergestellte Kammerkörperplatte (11) oder die Kammerabdeckplatte (12) definierten Kältemittel-Füllraum entspricht, ferner umfassend ein Nass-Cu-Beschichtungsverfahren (S30), bei dem zusätzlich eine Cu-Beschichtung auf dem durch das chemische Ni-Beschichtungsverfahren gebildeten Docht (14) durchgeführt wird.

6. Verfahren nach Anspruch 5, wobei der Materialvorbereitungsprozess einem Zinkatierungsverfahren (S14) vorausgeht, nachdem durch Ätzen mindestens einer der in Form einer Aluminiumplatte hergestellten Kammerkörperplatten (11) und Kammerabdeckplatten (12) ein dem Kältemittel-Füllraum entsprechender Hohlraum gebildet wurde, so dass der Docht (14) im Kältemittel-Füllraum gebildet wird.

7. Verfahren nach Anspruch 5, wobei der chemische Ni-Beschichtungsvorgang (S20) ein Vorgang ist, bei dem die mehreren Poren gebildet werden, während das Aluminiumpulver gebunden wird, und bei dem gleichzeitig der Docht (14) mit einer vorbestimmten Bindungskraft an eine Innenfläche der Kammerkörperplatte (11) oder der Kammerabdeckplatte (12) aus Aluminium gebunden wird, das dasselbe Material wie der Docht (14) ist.

8. Verfahren nach Anspruch 5, wobei der Nass-Cu-Beschichtungsvorgang (S30) ein Vorgang ist, bei dem eine Kupferschicht auf eine Oberfläche des durch den chemischen Ni-Beschichtungsvorgang gebildeten Dochtes (14) aufgebracht wird, um die mehreren Poren zu bilden, deren Größe so bemessen ist, dass das in den Kältemittel-Füllraum eingefüllte Kältemittel durch Kapillarwirkung fließt.

9. Verfahren nach Anspruch 5, wobei der Nass-Cu-Beschichtungsprozess (S30) ein Verfahren zum weiteren Erhöhen einer vorbestimmten Haftkraft des Dochtes (14) an der Kammerkörperplatte (11) oder des Dochtes (14) an der Kammerabdeckplatte (12) ist, die durch den chemischen Ni-Beschichtungsprozess hergestellt wurde.

10. Verfahren nach Anspruch 5, wobei, nachdem der chemische Ni-Beschichtungsprozess (S20) und der Nass-Cu-Beschichtungsprozess (S30) separat an der Kammerkörperplatte (11) und der Kammerdeckplatte (12) durchgeführt wurden, ein zusätzlicher Verbindungsprozess durchgeführt wird, bei dem die Kammerkörperplatte (11) und die Kammerdeckplatte (12) so verschweißt werden, dass der Docht (14) in Oberflächenkontakt mit der Kammerkörperplatte (11) und der Kammerdeckplatte (12) steht.

## Revendications

1. Chambre à vapeur (10) comprenant :
une plaque formant corps de chambre (11) dont une surface est en contact étroit avec une surface chauffante d'un élément chauffant (7) et dont l'autre surface est ouverte, la plaque formant corps de chambre (11) comportant un espace de remplissage de réfrigérant rempli d'un réfrigérant et défini pour présenter une épaisseur prédéterminée ;
une plaque de couvercle de chambre (12) fixée de manière à recouvrir l'autre surface ouverte de la plaque de corps de chambre (11) ; et
une mèche (14) formée dans l'espace de remplissage de réfrigérant, qui est l'espace situé entre la plaque de corps de chambre (11) et la plaque de couvercle de chambre (12), la mèche (14) comportant au moins plusieurs pores à travers lesquels s'écoule le réfrigérant remplissant l'espace de remplissage de réfrigérant,
**caractérisé en ce que** la mèche (14) comprend une couche de placage de Ni formée sur une surface extérieure de poudre d'aluminium agglomérée en unités de particules, la plaque de corps de chambre (11) et la plaque de couvercle de chambre (12) sont en aluminium, qui est le même matériau que la mèche (14) avant un procédé de nickelage chimique, la mèche (14) comprenant en outre une couche de cuivre formée sur la surface extérieure de la couche de nickel.

2. Chambre à vapeur (10) selon la revendication 1, dans laquelle la plaque de corps de chambre (11) et la mèche (14) ou la plaque de couvercle de chambre (12) et la mèche (14) sont liées avec une force de liaison prédéterminée grâce au procédé de nickelage sans courant.

3. Chambre à vapeur (10) selon la revendication 1, dans laquelle une force d'adhérence prédéterminée entre une surface interne de la plaque de corps de chambre (11) et la mèche (14) est encore augmentée par l'ajout d'un procédé de placage de cuivre par voie humide pour former la couche de placage de cuivre.

4. Chambre à vapeur (10) selon la revendication 3, dans laquelle les multiples pores formés dans la mèche (14) sont dimensionnés de telle sorte que le fluide frigorigène s'écoule par capillarité à travers la couche de cuivrage formée par le procédé de cuivrage humide.

5. Procédé de fabrication de chambres à vapeur selon la revendication 1, comprenant :
un procédé de préparation des matériaux (S10) consistant à préparer chaque matière première pour une plaque de corps de chambre (11), une plaque de couvercle de chambre (12) et une mèche (14), la plaque de corps de chambre (11) comportant un espace de remplissage de fluide frigorigène rempli d'un fluide frigorigène, la plaque de couvercle de chambre (12) étant configurée pour recouvrir une surface ouverte afin de définir l'espace de remplissage de fluide frigorigène conjointement avec la plaque de corps de chambre (11), la mèche (14) étant formée dans l'espace de remplissage de fluide frigorigène ; et
un procédé de nickelage chimique (S20) consistant à effectuer un nickelage chimique après qu'une quantité prédéterminée de poudre d'aluminium, qui constitue la matière première de la mèche (14), a été placée dans une zone correspondant à l'espace de remplissage de réfrigérant défini par la plaque de corps de chambre (11) ou la plaque de couvercle de chambre (12) préparée au cours du procédé de préparation des matériaux, comprenant en outre un procédé de placage de cuivre par voie humide (S30) consistant à effectuer en outre un placage de cuivre sur la mèche (14) formée au cours du procédé de placage de nickel sans courant.

6. Procédé selon la revendication 5, dans lequel le processus de préparation du matériau précède un processus de traitement au zincate (S14) après la formation d'un espace vide correspondant à l'espace de remplissage de réfrigérant par gravure d'au moins l'une parmi la plaque de corps de chambre (11) et la plaque de couvercle de chambre (12) préparées sous la forme d'une plaque d'aluminium, de sorte que la mèche (14) soit formée dans l'espace de remplissage de réfrigérant.

7. Procédé selon la revendication 5, dans lequel le procédé de nickelage chimique (S20) consiste à former les multiples pores tout en liant la poudre d'aluminium, et à lier simultanément la mèche (14) à une surface interne de la plaque de corps de chambre (11) ou de la plaque de couvercle de chambre (12) en aluminium, qui est le même matériau que la mèche (14), avec une force de liaison prédéterminée.

8. Procédé selon la revendication 5, dans lequel le procédé de placage de cuivre par voie humide (S30) consiste à déposer une couche de cuivre sur une surface de la mèche (14) formée par le procédé de placage de nickel sans courant, afin de former les multiples pores dimensionnés de telle sorte que le fluide frigorigène introduit dans l'espace de remplissage s'écoule par capillarité.

9. Procédé selon la revendication 5, dans lequel le procédé de placage humide au cuivre (S30) consiste à augmenter encore une force d'adhérence prédéterminée de la mèche (14) par rapport à la plaque du corps de chambre (11) ou de la mèche (14) par rapport à la plaque de couvercle de chambre (12), obtenue par le procédé de placage au nickel sans courant.

10. Procédé selon la revendication 5, dans lequel, après que le procédé de nickelage chimique (S20) et le procédé de cuivrage humide (S30) ont été effectués séparément sur la plaque de corps de chambre (11) et la plaque de couvercle de chambre (12), un procédé d'assemblage supplémentaire est effectué, consistant à souder la plaque de corps de chambre (11) et la plaque de couvercle de chambre (12) de telle sorte que la mèche (14) soit en contact de surface avec la plaque de corps de chambre (11) et la plaque de couvercle de chambre (12).
